# EUROPEAN PATENT APPLICATION

(11) **EP 4 535 410 A1**
(43) Date of publication of application: **09.04.2025**
(21) Application number: 23201533.9
(22) Date of filing: 04.10.2023
(51) Int. Cl.: H01L 21/68, H01L 21/687

(54) **PIN-LIFTER WITH POSITIONING COMPENSATION**

(71) Applicant: VAT Holding AG, 9469 Haag (CH)
(72) Inventor: KÜHNE, Clemens, 7317 Valens (CH); ROBUSTELLI, Fabio, 9469 Haag (CH); WONG, Bruno, 9470 Buchs (CH)
(74) Representative: Kaminski Harmann

(57) **Abstract**

Pin lifting device (10) configured for moving and positioning a substrate (1) to be processed in a process atmosphere region (P), the pin lifting device (10) comprises a lifting unit with a mount (11) configured to hold at least one lift pin (7a-7c) and a drive unit (14) which is connected to the mount (11) and which interacts with the mount (11) in such a way that the mount (11) is movable along a movement axis (M) from a lowered normal position into an elevated lifting position, and back again. The pin lifting device (10) comprises an adjusting structure (21) configured to interact with the lifting unit and an actuating unit (22) coupled to the adjusting structure (21) and coupled to the lifting unit so that movement of the adjusting structure (21) relative to the lifting unit according to at least one degree of freedom different from the moveability along the movement axis (M) is providable.

## Description

The invention relates to a pin lifting device for moving and positioning a substrate in a process chamber.

Pin lifting devices, also known as pin lifters, are typically designed and provided for the reception and the defined positioning of a substrate to be processed in a process chamber. These are used, exemplarily, for vacuum chamber systems in the area of IC, semiconductor, flat panel or substrate production, which must take place in a protected atmosphere without the presence of contaminating particles.

Such vacuum chamber systems comprise, in particular, at least one evacuable vacuum chamber which is provided for receiving semiconductor elements or substrates to be processed or produced and which has at least one vacuum chamber opening, through which the semiconductor elements or other substrates can be guided into and out of the vacuum chamber. For example, in a production plant for semiconductor wafers or liquid crystal substrates, the highly sensitive semiconductor or liquid crystal elements pass sequentially through several process vacuum chambers in which the parts located within the process vacuum chambers are each processed by means of a processing device.

The process chambers often have at least one transfer valve whose cross-section is adapted to the substrate and the robot and through which the substrate can be transferred into the vacuum chamber and, if necessary, removed after the intended processing. Alternatively, a second transfer valve may be provided through which the processed substrate is removed from the chamber.

The substrate, e.g. a wafer, is guided, for example, by a suitably designed and controlled handler (e.g. robot arm), which can be guided through the opening in the process chamber provided by the transfer valve. The process chamber is then loaded by e.g. gripping the substrate with the handler, introducing the substrate into the process chamber and depositing the substrate in the chamber in a defined manner. The substrate can be removed through the same reverse process or a different one, or even through a second opening.

For the placement of the substrate in the chamber, respective mobility of the substrate must be ensured. For this purpose, pin lifting systems are used which may provide a plurality of support points for the substrate and thus a load distribution (due to the dead weight of the substrate) over the entire substrate.

The pins are preferably in a receiving position and the robot places the substrate on the pins in this position. Alternatively, the substrate can be brought into position by means of the robot over the support pins of the lifting device and then lifted by the pins. After the robot has moved away, the substrate is deposited by lowering the pins on a carrier, e.g. a potential plate (electrostatic chuck), and the robot arm, which typically carries the substrate, is moved out of the chamber, e.g. at the same time as the substrate is deposited. The pins can be lowered further after depositing the substrate and are then present separated from it, i.e. there is no contact between the pins and the substrate. After removing the robot arm and closing (and optionally introducing process gas or evacuating) the chamber, the processing step is performed.

A low force effect on the substrate can be important after the process step has been carried out in the chamber and when the substrate is subsequently raised, as the substrate can adhere to the carrier, for example. If the substrate is pushed away from the carrier too quickly, the substrate may break, as the adhesive forces cannot be overcome or resolved at least at certain contact points. In addition, even if contact is established between the support pins and the substrate, any impact with the substrate can lead to undesired stress (or breakage).

At the same time, in addition to the gentlest possible and careful treatment of the substrates to be processed, the shortest possible processing time should also be made possible. This means that the substrate can be brought into the defined conditions - loading and unloading position and processing position - in the chamber as quickly as possible.

To avoid unwanted shocks during the processing of semiconductor wafers, for example, US 6,481,723 B1 recommends the use of a special stop device instead of hard motion stops in a pin lifter. Any hard plastic stops should be replaced here by a combination of a softer designed stop part and a hard stop, wherein the contact with the soft stop part is first made for the limitation of movement and then the hard stop is brought into contact with the soft stop part and damped accordingly.

US 6,646,857 B2 proposes a regulation of the lifting movement by means of a recorded occurring force. The lifting pins can be moved as a function of the force signal received so that the lifting force at the lifting pins is always applied to the wafer in a controlled and dosed manner.

To further improve processing time of substrates, more than only one substrate can be brought into the processing chamber and can be processed at the same time. However, simultaneous handling of multiple substrates is more challenging. As for example, if several substrates (wafers) are simultaneously carried by a wafer handler it is required to provide a particular position and/or orientation of each of the substrates while carrying the substrates as well as when depositing the substrates on the chuck. By that, desired processing of each of the wafers can be reproduced.

However, since mentioned positioning of the substrates is that challenging and processing times should be kept short, misalignment or torsions of the substrates can occur in the course of handling the substrate. As a consequence, in case the substrate is provides with some offset or distortion on the chuck, processing results may be deteriorated in comparison to processing results based in accurate positioning.

It is therefore the object of the present invention to provide an improved pin lifting device which reduces or avoids the above disadvantages.

In particular, it is the object of the invention to provide an improved pin lifting device which enables an optimized, i.e. in particular robust and precise, handling of a substrate to be processed.

These objects are achieved by realizing the characteristic features of the independent claims. Features which further develop the invention in an alternative or advantageous manner can be gathered from the dependent patent claims.

The invention relates to a pin lifting device, in particular pin lifter, configured for moving and positioning a substrate to be processed in a process atmosphere region. The substrate may be a wafer or any other semiconductor element. The process atmosphere region can typically be provided by a vacuum process chamber.

The pin lifting device comprises a lifting unit with a mount configured to hold at least one lift pin, wherein the at least one lift pin is adapted to contact and support the substrate. The pin lifting unit also comprises a drive unit which is connected to the mount and which interacts with the mount in such a way that the mount is, in particular linearly, movable along a movement axis from a lowered normal position into an elevated lifting position, and back again.

The drive unit can be designed as an electric motor, in particular a stepper motor, which provides a mechatronic pin lifting device. Alternatively, the drive unit can be designed as a pneumatic drive cylinder.

The lowered normal position is to be understood as a position of the mount to provide the at least one lift pin in a state substantially free of action with respect to its intended effect.

The intended effect of the support pin is essentially to pick up, contact, move, support and/or position etc. a workpiece or substrate. The lowered normal position of the lift pin is to be understood in this context as a state in which the pin is not in contact (not yet or no longer in contact) with a substrate to be contacted as intended and, in particular, is temporarily not providing the intended purpose, i.e. is provided, for example, in a lowered waiting position. This is in particular the case while a machining process is being carried out on the wafer.

The elevated lifting position is to be understood to provide the intended effect of the lifter of receiving and/or providing the substrate by the at least one lift pin. The elevated lifting position does not mean exclusively that there is contact between the lift pin and the substrate; rather, the pin can be present in this state in an extended state and held ready to receive a wafer (deposition of the wafer on the pin). The processes or movements (transport of the wafer) that subsequently can occur upon contact are also to be understood as providing the intended effect of a pin lifter.

The pin lifting device relates at least to a device in an unloaded mounting state in which a lift pin to be mounted on the mount is not in a held position relative to the mount; in other words: the pin is not present. In a mounted state, the lift pin can be held by the mount in a received desired position. It is understood that the invention relates to the pin lifting device with and without a mounted lift pin.

The pin lifting device comprises an adjusting structure configured to interact with the lifting unit and an actuating unit coupled to the adjusting structure and coupled to the lifting unit so that movement of the adjusting structure relative to the lifting unit according to at least one degree of freedom different from the moveability along the movement axis is providable.

By means of the moveable adjusting structure, the pin lifting device according to the invention can provide movement of a substrate not only in one movement direction but also in at least one additional direction (translationally or rotationally). By that, the pin lifting device according to the invention can provide for exact positioning of the substrate with high accuracy.

In one embodiment, the adjusting structure can be configured to interact with at least one adjusting pin of the at least one lift pin and the at least one adjusting pin is moveable according to the at least one degree of freedom different from the (e.g. linear) moveability along the movement axis by movement of the adjusting structure.

Hence, as for example, the pin lifter may comprise several lift pins and mounts wherein a first part of the pins is designed to be moved only up and down and a second part of the pins (adjusting pins) can be moved by means of the adjusting structure in at least one additional degree of freedom.

According to one embodiment, the movement according to the at least one degree of freedom different from the moveability along the movement axis can comprise at least one of
- a linear movement in at least one direction transverse or orthogonal to the movement axis (M),
- a rotational movement about the movement axis, and
- a rotational movement about an axis orthogonal to the movement axis.

The adjusting structure can correspondingly be moved in a plane orthogonal to the movement axis and/or can be tilted relative to the movement axis.

In an embodiment, the mount can comprise at least one joint in particular a swivel joint, wherein the joint can be configured to provide tilting of the lift pin relative to the mount.

In a state of mounted lift pin at the mount, the adjusting structure can further interact with the lift pin and tilting of the pin can be provided by moving the adjusting structure.

In one embodiment, the adjusting structure can be provided by a flange or any other coupling element to mount the pin lifting device at a process chamber. The adjusting structure can also be provided by a wall, e.g. bottom wall, of a process chamber.

In one embodiment, the adjusting structure can comprise a feedthrough or recess which is configured to provide extending (passing) of the lift pin through the adjusting structure. The feedthrough can provide a guidance for the lift pin and thus provide movement relative to the moving axis.

In particular, the feedthrough can comprise a sealing component, in particular an O-ring or a bellows. The sealing component can provide atmospheric separation of a processing volume from the machine part of the pin lifter. In case the adjusting structure provides a part of the processing chamber the sealing component can provide atmospheric tightness of the processing chamber while providing movement of the lift pin in the processing chamber.

In particular, the sealing component can be designed to also allow movement of the pin orthogonal to the movement axis or to allow rotation of the pin relative to the movement axis.

A suitable material for such sealing component, in particular for an O-ring in vacuum systems, is, for example, fluororubber or fluoroelastomer, in particular perfluorubber.

According to one embodiment, the mount can comprise at least three joints to hold at least three lift pins and the adjusting structure can comprise at least three feedthroughs to provide extending of the at least three lift pins through the adjusting structure, wherein movability of the at least three lift pins in the at least one degree of freedom different from the moveability along the movement axis is providable by relative movement between the adjusting structure and the mount.

In one embodiment, the adjusting structure can comprise a base plate with at least three feedthroughs, wherein the feedthroughs can be arranged in a border region of the base plate and can be equally distributed about the circumference of the base plate.

The invention also relates to a pin lifting system. The pin lifting system comprises a pin lifting device of above and a controlling unit. The controlling unit is configured to control at least the actuating unit of the pin lifting device. In particular, controlling can be provided by means of a corresponding adjusting functionality which can be implemented on the controlling unit.

Controlling of the actuating unit is provided by receiving a positioning information concerning a position of a substrate relative to the pin lifting device. In particular, the positioning information can result from providing the substrate on the pin lifting device, i.e. from the step of handling of the substrate or from depositing the substrate on the lifter. In particular, the positioning information can be further processed by the controlling unit to provide specific position data.

A controlling signal is derived based on the positioning information and the controlling signal is applied to the actuating unit.

In one embodiment, the positioning information can comprise at least one of the following:
- a positional offset information,
- a misalignment information,
- a current position of the substrate, and
- a current orientation of the substrate.

The positional offset information and the misalignment information preferably relates to an offset or misalignment of the substrate relative to the lifting unit, in particular relative to a reference point defined by the pin lifting device.

In one embodiment, deriving the controlling signal can comprise processing the positioning information by comparing a defined reference positioning information with an actual positioning information related to an actual position and/or orientation of the substrate relative to the pin lifting device, in particular relative to the lifting unit.

According to an embodiment, the controlling unit can be configured to control the actuating unit by receiving or deriving a positional and/or orientational offset of the substrate relative to the pin lifting device, and providing movement of the adjusting structure by means of the actuating unit so that the positional and/or orientational offset is compensated. In particular, the positional and/or orientational offset represents the positioning information.

In one embodiment, the pin lifting system can comprise at least one lift pin connected to the mount of the pin lifting device and the positioning information results from providing the substrate on the at least one lift pin. Alternatively or additionally, the pin lifting system can comprise a substrate handler, e.g. a robot, to provide the substrate on the pin lifting device, in particular on the at least one lift pin.

The invention also relates to a method for compensating a position of a substrate relative to a pin lifting device, in particular relative to a drive unit or mount of the pin lifting device. The pin lifting device is embodied as described above.

The method comprises
- receiving a positioning information concerning a position of a substrate relative to the pin lifting device, in particular resulting from providing the substrate on the pin lifting device and/or handling the substrate,
- deriving a controlling signal based on the positioning information, and
- applying the controlling signal to the actuating unit of the pin lifting device.

The invention also relates to a computer program product, which, when executed by a controlling unit (e.g. of the pin lifting device), causes the automatic execution and controlling of the steps of the method of above. The method of above can be implements in the computer program product.

The devices and method according to the invention are described or explained in more detail below, purely by way of example, with reference to working examples shown schematically in the drawings. Specifically,
- fig. 1: shows an embodiment of a process setup for processing a semiconductor wafer;
- fig. 2: shows an embodiment of a pin lifting system according to the invention with a pin lifting device and a controlling unit; and
- fig. 3a-4b: show an embodiment of a pin lifting device according to the invention.

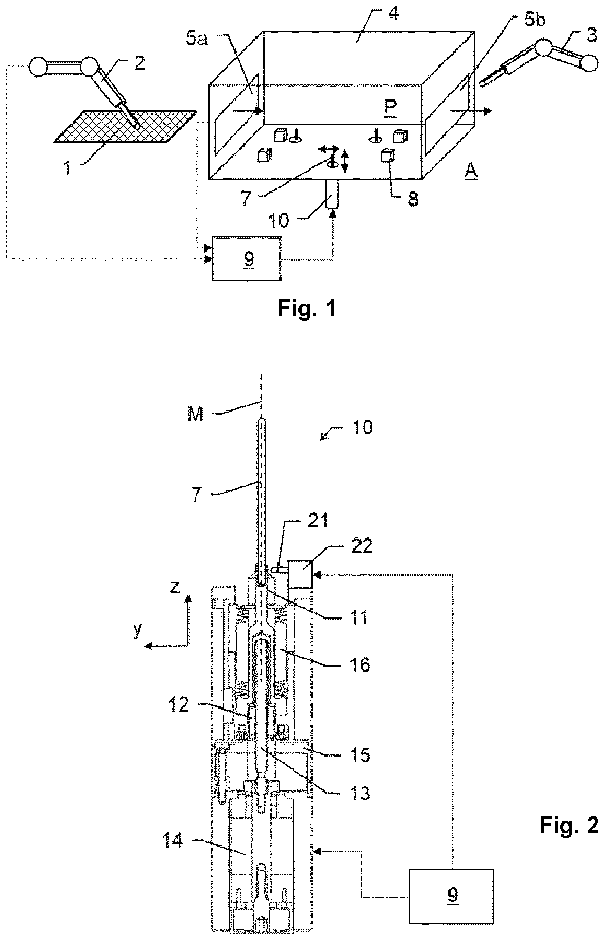

Figure 1 schematically shows a process setup for processing a semiconductor wafer 1 (substrate) under vacuum conditions. The wafer 1 is introduced into a vacuum chamber 4 (process atmosphere area P) by means of a first robot arm or handler 2 through a first vacuum transfer valve 5a and brought into position via lift pins 7 of a pin lifting device 10 according to the invention (here: three pins shown). The wafer 1 is picked up by means of movement of the pins 7 or deposited thereon and the robot arm 2 is moved away.

The wafer 1 typically rests on the robot arm or a support device provided by the robot arm 2,3 or is held by means of a specific support device. After the wafer 1 is hold by the pins 7, the robot arm is guided out of the chamber 4 and the transfer valve 5a is closed.

The process setup comprises a measuring system to provide information about a current position of the wafer 1 relative to the robot arm 2 and/or relative to the pin lifting device (or the lift pins). By that, a possible deviation of the position and/or orientation of the substrate from a reference position and/or orientation can be detected. The reference position and/or orientation preferably represents a desired position and/or orientation of the substrate in the processing system, e.g. when deposited for processing. Correspondingly, a respective offset or misalignment can be calculated based thereon.

The pin lifting device according to the invention comprises an actuating unit (additional to a typical drive unit) which is implemented to provide a movement of the pins in at least one direction different from the linear lifting or lowering movement of the pins (described in more detail below). The actuating unit can be controlled to provide the movement of the pins in a defined direction and according to a desired amount (distance).

The system also comprises a controlling unit 9 which is configured to receive and/or process position information concerning the possible deviation of the position and/or orientation of the substrate from the reference position and/or orientation. The controlling unit 9 derives a controlling signal based on the identified deviation. The controlling signal is adapted to control the actuating unit. The controlling signal can comprise an information about a direction and/or distance which the substrate would have to be moved in order to approach or reach a refence state.

The controlling unit is further configured to apply the controlling signal to the actuating unit. By that, the lift pins can be moved by means of driving the actuating unit according to the controlling signal. Correspondingly, the measured deviation of the state of the substrate can be compensated, i.e. at least reduced or totally compensated.

Preferably after such compensation, the pins 7 can be lowered. This is done by means of a (main) drive unit of the pin lifting device 10 which is coupled to the respective pins 7. The wafer 1 can thereby be deposited on the four support elements 8 shown. Alternatively, the wafer 1 is deposited on an electrostatic device (not shown), a so-called electrostatic chuck, and held in place by applying an electrical voltage between the chuck electrodes and, if necessary, leveled by the forces acting through this. Electrostatic chucks are typically used for processing of semiconductor wafers under vacuum conditions.

In this state, a planned processing (e.g. coating, etching, atomic layer deposition etc.) of the wafer 7 takes place under defined vacuum conditions, in particular in a defined atmosphere (i.e. with a specific process gas and under defined pressure). For this purpose, the chamber 4 is coupled to a process gas source, a vacuum pump and preferably a vacuum control valve for controlling the chamber pressure (not shown).

After processing, the wafer 1 is lifted into an elevated removal position again by means of the pin lifting device 10. The second robot arm 3 is subsequently used to remove the wafer 1 through the second transfer valve 5b. Alternatively, the process may be designed with only one robot arm, in which case placement and removal may be performed through a single transfer valve.

The controlling unit 9 may be communicatively (e.g., wirelessly via radio, WiFi, Bluetooth, etc.) and/or electronically and/or electrically connected to the pin lifting device. Further, the controlling unit 9 may be integrated into the pin lifting device of the system. The controlling unit 9 may be designed to communicate wirelessly with several pin lifters and provide individual control and receipt of respective information for each individual pin lifter.

The controlling unit may be physically separated from the pin lifting device and may comprise, for example, a tablet PC, a cell phone, and/or a computer workstation.

The pin lifting system according to the invention enables to correct a position of a wafer even if the wafer is brought in the process chamber with a particular offset and even if the wafer is deposited on the pins with a particular offset relative to a desired processing position. By that, processing of the wafer can be provided with more precision and robustness.

A further advantage is that a handling system for providing the wafer can be built to accept greater tolerance and, as consequence therefrom, to provide faster transportation and deposition of the wafer. Total processing time can thus be reduced.

Figure 2 shows an embodiment of a pin lifting system according to the invention with a pin lifting device 10 and a controlling unit 9.

A lift pin 7 is arranged at a mount 11 (e.g. a coupling) of the device 10. The lift pin 7 preferably comprises a metallic, polymer-based or ceramic material, in particular the pin 7 is made entirely of such a material. The connection of the pin may be realized, for example, magnetically or by means of a clamping.

The mount 11 can be moved in the z-direction along a movement axis M by means of a slider 12. For this purpose, the slider 12 is coupled to a threaded spindle 13, which in turn can be driven by an electric motor of the drive unit 14.

According to another embodiment, the drive unit 14 of a pin lifting device according to the invention can be provided by a pneumatic drive.

In one embodiment, optional thermal and electrical insulation between the upper mount part and the lower drive part is provided by a first insulating element 15 that thermally and electrically separates an upper housing part from a lower housing part. Preferably, a second insulating element, which may be embodied by the slider 12, may be provided. In this embodiment of the pin lifting device 10, the threaded spindle 13 is designed and mounted in such a precise and rigid manner that no (electrically or thermally conductive) contact occurs between the spindle 13 and the mount 11 - even during a relative movement.

Alternatively, the spindle 13 is made of or coated with a non-conductive or thermally insulating material. Thus, complete galvanic and thermal isolation is provided between the upper and lower portions in any state of the device 10.

In a further embodiment, both the threaded spindle 13 and the slider 12 seated on the spindle 13 may be manufactured to be conductive (e.g. metallic). Insulation can then be implemented in particular by means of, for example, an intermediate sleeve between the spindle/slider and the mount.

It is to be understood that the above embodiments are purely optional, but the invention also relates to embodiments with alternative driving and coupling approaches to provide linear movement of the mount 11 and the lift pin 7 in a direction according to the movement axis M.

The pin lifter 10 further comprises a bellows 16 inside. The bellows 16 is arranged and shaped such that an atmospheric separation is provided between a process atmosphere region P, in which the lift pin 7 can be present and in which a processing of a substrate usually takes place, and an external atmosphere region A, in which, for example, the drive 14 and other peripheral components may be present. The bellows 16 is compressed when the pin 7 is extended (moved in upward direction), while maintaining atmospheric separation.

The pin lifting device can be connected to a housing of a vacuum process chamber.

It is to be understood that a pin lifting device according to the invention may alternatively have realized another sealing concept instead of a bellows, which also provides an atmospheric separation, for example a radial sealing in the upper outlet area of the support pin 7 with e.g. an 0-ring or a diaphragm.

The pin lifting device also comprises an adjusting structure 21 and an actuating unit 22. Here, the adjusting structure 21 is embodied as a bolt.

The actuating unit 22 is coupled with the adjusting structure 21 and coupled to the lifting unit so that movement of the adjusting structure 21 relative to the lifting unit according to at least one degree of freedom different from the linear moveability along the movement axis M is providable. The lifting unit may comprise the mount, the drive unit, the housing or the like.

The actuating unit 22 may be embodied as a motor or piezo actor and provides a variation of the position of the bolt in a direction orthogonal to the movement axis M, i.e. in y-direction.

The controlling unit 9 is configured to control the actuating unit 22 (and the drive unit 12). A respective controlling signal to move the actuating unit 22 can be derived on basis of position information regarding a position of a substrate which is intended to be moved by the pin lifter 10 relative to the pin lifter 10. The position information may comprise a position and/or orientation of the substrate relative to the pin lifting device 10 before contacting the pin 7 of the lifter 10. Alternatively or additionally, the position information may comprise a position and/or orientation of the substrate relative to the pin lifting device 10 when supported by the pin lifting device 10.

Based on the position information, an offset and/or misalignment of the substrate relative to the pin lifting device 10 can be calculated. Then, the controlling unit 9 can provide to derive a corresponding controlling signal to control the actuating unit 22 so that e.g. the offset is compensated. As for example, the controlling unit 9 provides a particular movement of the bolt 21 of such distance that a particular y-offset is compensated, i.e. reduced or dissolved.

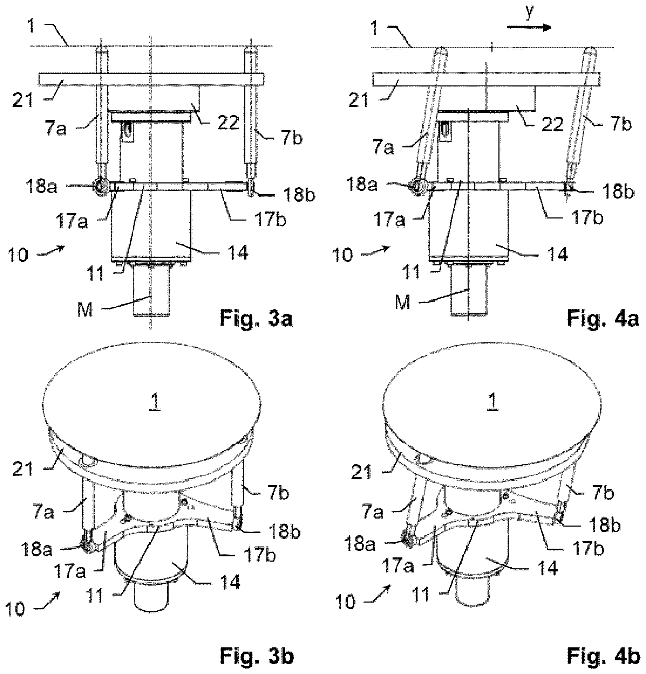

Figures 3a to 4b show an embodiment of a pin lifting device 10 according to the invention. Figures 3a and 4a are side views of the device 10 and figure 3b and 4b shows the device in particular perspective.

The pin lifting device 10 comprises a mount 11 and a drive unit 14, wherein the mount 11 is connected to the dive unit 14 to be moved along the movement axis M by means of the drive unit 14.

Here, the drive unit 14 comprises an electric motor. However, according to an alternative embodiment, the drive unit 14 may comprise a pneumatic drive to provide the movement of the mount 11.

The mount 11 is (here: centrally) coupled to the drive unit 14 and comprises three arms 17a-17c (arm 17c is not visible in the figures because of occlusion by drive unit 14). The arms 17a-17c are equally distributed about the circumference of the drive unit 14. Each arm is connected to one lift pin 7a-7c (lift pin 7c is not visible in the figures because of occlusion by drive unit 14). Respective swivel joints 18a-18c are provided in order to provide swiveling or tilting of the pins 7a-7c relative to the mount 11.

The pin lifting device 10 further comprises an adjusting structure 21 and an actuating unit 22. The adjusting structure 21 is embodied as a base plate 21. The base plate 21 comprises three feedthroughs (recesses), wherein each feedthrough is passed by a one of the lift pins 7a-7c. Each feedthrough comprises a sealing element to provide atmospheric separation despite the openings provided by the feedthroughs.

The actuating unit 22 is arranged between the drive unit 14 and the base plate 21. The actuating unit 22 is configured to provide a relative movement of the base plate 21 and the drive unit 14. The actuating unit 22 can comprise at least one drive and at least one guidance to provide movement in one direction. In particular, the actuating unit 22 can comprise at least two drives and at least two guidance to provide movement in two directions.

The actuating unit 22 can comprise a piezo element as an actor to provide relative movement.

Referring to figures 4a and 4b, the pin lifting device 10 is shown after providing relative movement of the base plate 21 and the drive unit 14. As can be seen, the actuating unit 22 can provide movement of the base plate 21 relative to the drive unit 14 along a y-axis, i.e. in y-direction. Due to such movement the three lift pins 7a-7c are correspondingly moved in y-direction.

By that, a substrate 1 deposited on top of the pins 7a-7c can also be moved in y-direction. A possible position offset of the substrate 1 related to the y-axis (e.g. relative to the drive unit 14) can be compensated by such counteracting. The design of the pin lifting device 10 can provide horizontal movement of the substrate 1 without and tilting of the substrate 1.

The actuating unit 22 can further be configured to provide movement of the base plate 21 in an additional lateral direction (e.g. x- direction) and/or a rotational movement about the x-axis and/or the y-axis.

According to an alternative embodiment, the base plate 21 can be fixedly arranged e.g. at the process chamber or can be provided by a bottom wall of the process chamber and the actuating unio provides movement of the drive unit 14 relative to the base plate 21. As a result, the lift pins 7a-7c can also be moved like described above.

Although the invention is illustrated above, partly with reference to some specific embodiments, it must be understood that numerous modifications and combinations of different features of the embodiments can be made and that the different features can be combined with each other or with vacuum applications known from prior art.

## Claims

1. Pin lifting device (10) configured for moving and positioning a substrate (1) to be processed in a process atmosphere region (P) which is providable by a vacuum process chamber (4), the pin lifting device (10) comprises a lifting unit with
• a mount (11) configured to hold at least one lift pin (7,7a-7c), the at least one lift pin (7,7a-7c) being adapted to contact and support the substrate (1), and
• a drive unit (14) which is connected to the mount (11) and which interacts with the mount (11) in such a way that the mount (11) is movable along a movement axis (M) from
□ a lowered normal position into
□ an elevated lifting position, and back again,
**characterised in that**
the pin lifting device (10) comprises
• an adjusting structure (21) configured to interact with the lifting unit and
• an actuating unit (22) coupled to the adjusting structure (21) and coupled to the lifting unit so that movement of the adjusting structure (21) relative to the lifting unit according to at least one degree of freedom different from the moveability along the movement axis (M) is providable.

2. Pin lifting device (10) according to claim 1, wherein the adjusting structure (21) is configured to interact with at least one adjusting pin of the at least one lift pin (7,7a-7c) and the at least one adjusting pin is moveable according to the at least one degree of freedom different from the moveability along the movement axis (M) by movement of the adjusting structure (21).

3. Pin lifting device (10) according to claim 1 or 2,
wherein
the movement according to the at least one degree of freedom different from the moveability along the movement axis (M) comprises at least one of
• a linear movement in at least one direction transverse or orthogonal to the movement axis (M),
• a rotational movement about the movement axis (M),
• a rotational movement about an axis orthogonal to the movement axis (M).

4. Pin lifting device (10) according to any one of the preceding claims, wherein
the mount (11) comprises a joint (18a-18c), in particular a swivel joint, wherein the joint (18a-18c) is configured to provide tilting of the lift pin (7,7a-7c) relative to the mount (11).

5. Pin lifting device (10) according to any one of the preceding claims, wherein
the adjusting structure (21) comprises a feedthrough configured to provide extending of the lift pin (7,7a-7c) through the adjusting structure (21).

6. Pin lifting device (10) according to claim 5, wherein the feedthrough comprises a sealing component, in particular an O-ring or a bellows.

7. Pin lifting device (10) according to any one of the preceding claims, wherein
the mount (11) comprises at least three joints (18a-18c) to hold at least three lift pins (7a-7c) and the adjusting structure (21) comprises at least three feedthroughs to provide extending of the at least three lift pins (7a-7c) through the adjusting structure (21), wherein movability of the at least three lift pins (7a-7c) in the at least one degree of freedom different from the moveability along the movement axis (M) is providable by relative movement of the adjusting structure (21) and the mount (11).

8. Pin lifting device (10) according to any one of the preceding claims, wherein
the adjusting structure (21) comprises a base plate with at least three feedthroughs, wherein the feedthroughs are arranged in a border region of the base plate and are equally distributed about the circumference of the base plate.

9. Pin lifting system comprising
• a pin lifting device (10) according to any one of the preceding claims and
• a controlling unit (9) configured to control at least the actuating unit (22) of the pin lifting device (10) by
□ receiving a positioning information concerning a position of a substrate (1) relative to the pin lifting device (10),
□ deriving a controlling signal based on the positioning information, and
□ applying the controlling signal to the actuating unit.

10. Pin lifting system according to claim 9, wherein
the positioning information comprises at least one of the following:
• a positional offset information,
• a misalignment information,
• a current position of the substrate (1),
• a current orientation of the substrate (1).

11. Pin lifting system according to claim 9 or 10, wherein deriving the controlling signal comprises processing the positioning information by comparing a defined reference positioning information with an actual positioning information related to an actual position and/or orientation of the substrate (1) relative to the pin lifting device (10).

12. Pin lifting system according to any of the claims 9 to 11, wherein
the controlling unit (9) is configured to control the actuating unit (22) by
• receiving or deriving a positional and/or orientational offset of the substrate (1) relative to the pin lifting device (10), and
• providing movement of the adjusting structure (21) by means of the actuating unit (22) so that the positional and/or orientational offset is compensated.

13. Pin lifting system according to any of the claims 9 to 12, wherein
• the pin lifting system comprises at least one lift pin connected to the mount of the pin lifting device (10) and the positioning information results from providing the substrate on the at least one lift pin, and/or
• the pin lifting system comprises a substrate handler to provide a substrate on the pin lifting device (10).

14. Method for compensating a position of a substrate relative to a pin lifting device (10) according to any of the claims 1 to 8, the method comprising
• receiving a positioning information concerning a position of a substrate relative to the pin lifting device (10),
• deriving a controlling signal based on the processing of the positioning information, and
• applying the controlling signal to the actuating unit of the pin lifting device (10).

15. Computer program product, which, when executed by a controlling unit, causes the automatic execution and controlling of the steps of the method according to claim 14.
